# EUROPEAN PATENT SPECIFICATION

(11) **EP 1 935 091 B1**
(45) Date of publication and mention of the grant of the patent: **13.02.2013**
(21) Application number: 06807101.8
(22) Date of filing: 09.10.2006
(51) Int. Cl.: H03F 1/08, H03F 3/08, H03F 3/45

(54) **SYSTEMS AND METHODS FOR TRANSFERRING SINGLE-ENDED BURST SIGNAL ONTO DIFFERENTIAL LINES, ESPECIALLY FOR USE IN BURST-MODE RECEIVER**
SYSTEME UND VERFAHREN ZUM TRANSFERIEREN EINES ASYMMETRISCHEN BURST-SIGNALS AUF DIFFERENZLEITUNGEN INSBESONDERE FÜR DIE VERWENDUNG IN EINEM BURST-MODUS-EMPFÄNGER
SYSTEME ET PROCEDES DE TRANSFERT EN RAFALES DE SIGNAUX MONOCORDES SUR DES LIGNES DIFFERENTIELLES ET SPECIALEMENT A USAGE DE RECEPTEURS EN MODE RAFALE

(30) Priority: 07.10.2005 US 724449 P; 01.09.2006 US 841816 P
(43) Date of publication of application: 25.06.2008
(73) Proprietor: IMEC, 3001 Leuven (BE); Universiteit Gent (RUG), 9000 Gent (BE)
(72) Inventor: OSSIEUR, Peter, B-8200 Brugge (BE); DE RIDDER, Tine, B-9052 Zwijnaarde (BE); BAUWELINCK, Johan, B-9140 Temse (BE); QIU, Xing-Zhi, B-9032 Wondelgem-Gent (BE); VANDEWEGE, Jan, B-9030 Mariakerke-Gent (BE)
(74) Representative: Sarlet, Steven Renaat Irène
(86) International application number: PCT/EP2006/067215
(87) International publication number: WO 2007/042507

(56) References cited:
- EP-A- 0 580 089
- EP-A- 0 736 968
- EP-A- 0 838 914
- US-A- 6 141 169

## Description

### Field of the invention

The invention relates to systems and methods for transferring incoming single-ended burst signals of which at least one characteristic varies widely from burst to burst onto a pair of differential lines. The systems and methods of the invention can for example be used in an optical receiver in optical fiber networks, especially if these networks require burst-mode transmission, in particular passive optical networks, for instance gigabit passive optical networks.

### Background of the invention

Burst-mode transimpedance amplifiers (B-TIA), intended for use in the optical line termination (OLT) of gigabit passive optical networks (GPON), are preferably compliant to the ITU-T G.984.2 standard.

Burst-mode TIA must handle the upstream burst-mode transmission with the property that the signals arriving at the OLT consist of a rapid sequence of bursts with widely varying amplitudes from burst to burst.

Furthermore, to support the ITU-T G.984.2 class B, class B+ and class C operation, a TIA must have a large dynamic range. This can be provided by introducing means to provide a variable gain. Gain switching can extend the dynamic range, i.e. the level difference between the weakest and the strongest bursts that can be received.

A major problem in the development of a TIA front-end for a GPON system is the fact that after each burst, a reset signal is needed to prepare the receiver circuitry for a next burst. Indeed, in a conventional burst-mode receiver the automatic gain control circuitry needs to be reset after each burst.

When the guard time between bursts can be shorter than the maximum number of consecutive identical digits in a burst, it is not possible to detect the guard time between bursts. In that case in classical B-TIA's a reset signal needs to be provided externally to the TIA.

Usually, such a reset signal needs at least one additional I/O pin. This makes it difficult to integrate a TIA for GPON applications into the industry standard 5-pins TO-can package. Indeed, to ensure sufficient high sensitivity for class B, class B+ or class Cooperation an avalanche photodiode is required. Then, the following pins are needed:
- Positive supply voltage for the TIA
- Bias voltage for the avalanche photodiode
- Negative supply voltage for the TIA (gnd)
- Positive phase of the differential output
- Negative phase of the differential output

Hence, all 5 pins have been used, and no pins are left to provide a reset signal. In case only a PIN photodiode is used, one pin less can be used for monitoring. However, if one wants an additional RSSI (Received Signal Strength Indication) pin, the same problem remains, i.e. additional pins are needed on the TO-can package.

One may conclude that prior art transimpedance amplifiers (TIA), that require gain switching on a per-burst basis, hereafter also referred to as a burst-mode transimpedance amplifier or B-TIA, require at least one additional I/O pin to provide a reset signal to the automatic gain adjustment circuitry or any other adaptation circuitry which needs to be set for each burst. When the guard time between bursts can be shorter than the maximum number of consecutive identical digits in a burst, it is not possible to automatically detect the guard time between bursts. In that case prior-art variable-gain burst-mode transimpedance amplifiers require a reset signal to be provided externally, with the packaging problems as described before.

### Summary of the invention

In a first aspect of the invention, it is an aim to provide a system and method for transferring incoming single-ended burst signals of which at least one characteristic varies widely from burst to burst onto a pair of differential lines, with which the need for an additional I/O pin for a reset signal can be avoided.

This aim is achieved according to the first aspect of invention with the system according to claim 1 and the method according to claim 11.

In a second aspect of the invention, it is an aim to provide a system and method for transferring incoming single-ended burst signals with widely varying amplitudes from burst to burst onto a pair of differential lines, with which signal adaptations during data transmission can be avoided.

This aim is achieved according to the second aspect of invention with the system according to claim 13 and the method according to claim 18.

The systems and methods of the first and second aspects of the invention can for example be applied in any front-end or receiver, for example in an optical receiver in optical fiber networks, especially if these networks require burst-mode transmission, in particular passive optical networks, for instance gigabit passive optical networks.

In the following, the first and second aspects of the invention will be described separately, although they may be combined.

The system according to the first aspect of the invention comprises the following components:
- an input for receiving an incoming burst signal,
- a signal adaptation block with at least one controllable adaptation element connected to said input and provided for adapting said at least one widely varying characteristic of the incoming burst signal,
- a single-ended-to-differential converter connected to said signal adaptation block for converting the burst signal to a differential signal to be placed on said pair of differential lines in forwards direction,
- an end-of-burst detector connected to said pair of differential lines and provided for detecting burst ends in said differential signal,
- a reset signal generator connected to said end-of-burst detector for generating a reset signal to be placed on said differential lines in backwards direction upon detection of one of said burst ends,
- a reset signal receptor connected to said pair of differential lines backwards from said reset signal generator, for receiving said reset signal,
- a settings determination block connected to said reset signal receptor and said signal adaptation block, for controlling each adaptation element of said signal adaptation block upon receipt of said reset signal on the basis of a measurement of the incoming burst signal.

In the system and method of the first aspect of the invention, the burst end is detected on the differential lines after which the reset signal is generated and placed on the differential lines in backwards direction. The reset signal is picked up by the reset signal receptor and passed on to the settings determination block, which controls the signal adaptation block. So the reset signal is supplied via two pins which are already present anyway, namely those to which the differential lines are connected. In this way, the need for an additional pin or input for the reset signal is avoided and the system can be integrated into standard packages.

When implementing the first aspect of the invention on a burst-mode transimpedance amplifier (B-TIA) and front-ends (receivers) including such B-TIA's, sufficiently fast (nanosecond scale) gain optimization at the start of each burst can be enabled. This gain optimization can extend the receiver dynamic range, and can be so fast and accurate that it causes no loss of sensitivity or data. As a result, the front-end (receiver) is provided with a means for setting the gain of said amplifier fast, in order to handle burst mode operation with widely varying amplitudes from burst to burst, without requiring more I/O pins for providing said reset signal.

The settings determination block is provided for measuring the incoming burst and determining a suitable setting for each adaptation element in the signal adaptation block on the basis of this measurement, in order to prepare the system for the next burst to be received. The measurement can be taken on the single line directly after the signal adaptation block or on the differential lines.

In an embodiment, the reset signal generator is provided for modifying the common-mode level on the differential lines and the reset signal receptor is a common-mode level measurement block. In this embodiment, the reset signal is a modification of the common-mode level on the differential lines. This embodiment has the advantage that it is easy to implement and that the reset signal does substantially not disturb the burst signal or any of the data on the differential lines.

In an embodiment, the signal adaptation block, single-ended-to-differential converter, reset signal receptor and settings determination block are integrated in a first chip and the end-of-burst detector and reset signal generator are integrated in a second chip. These first and second chips are connected by means of the pair of differential lines, on which the bursts are conducted in forwards direction from the first chip to the second chip and the reset signal is conducted in backwards direction from the second chip to the first chip.

In a preferred embodiment, the input is formed by a photodiode for placement at a termination of an optical line, for optical to electrical signal conversion, for example in gigabit passive optical networks.

In a preferred embodiment, said first chip is a four I/O pins package with two pins for a positive and a negative supply voltage and two pins forming a differential output for connection to said pair of differential lines.

In another preferred embodiment, said first chip is a five I/O pins package with two pins for a positive and a negative supply voltage, two pins forming a differential output for connection to said pair of differential lines and one pin for providing a received signal strength indication.

In another preferred embodiment, said first chip is a five I/O pins package with two pins for a positive and a negative supply voltage, two pins forming a differential output for connection to said pair of differential lines and one pin for supplying a bias voltage to said photodiode.

The widely varying characteristics which may be adapted in the systems and methods according to the first aspect of the invention can for example be the amplitude of the incoming burst, the DC-offset of the incoming burst and/or any other characteristic of the incoming burst signal known to the person skilled in the art.

The system according to the second aspect of the invention further comprises the following components:
- each incoming burst comprises a preamble and a subsequent data section,
- a status freezing mechanism connected to said input and said settings determination block, for freezing each adaptation element of said signal adaptation block during treatment of said data section of each incoming burst.

In the system and method of the second aspect of the invention, the settings of each controllable adaptation element are frozen during the stage in which the data section of the incoming burst is treated, i.e. the setting in the settings determination block is fixed at the value at which it has been set before during the preamble. In this way it can be avoided that the settings determination block can be triggered during treatment of the data section, which in absence of the status freezing mechanism may for example occur as a result of variations in the level of the burst and could lead to loss of data.

In a preferred embodiment, the start of the preamble is detected by comparing the incoming burst with an activity threshold in an activity detection block, which is connected to the input. When the activity threshold is crossed, a timer is triggered which has a predetermined time delay in function of the duration of the preamble. Upon completion of this time delay, a freezing signal is generated for the settings determination block, telling the latter that the preamble has passed and that each setting has to be frozen.

In a more preferred embodiment, the incoming burst is furthermore compared with an overload threshold by means of an overload detection block, which is connected to the input and is adapted for retriggering the timer and the freezing signal generator in the event that the overload threshold is crossed. This embodiment takes the problem into account that the activity threshold could be crossed prematurely, for example by the laser prebias field of a strong burst, causing early triggering of the timer. Without the overload detection, such could lead to the freezing of one or more settings before the determination of its value has been completed. The overload detection and retriggering of the timer overcomes this problem.

The widely varying characteristics which may be adapted in the systems and methods according to the second aspect of the invention can for example be the amplitude of the incoming burst, the DC-offset of the incoming burst and/or any other characteristic of the incoming burst signal known to the person skilled in the art.

In more general terms, the invention can also be formalized as follows.

According to the first aspect, the invention relates to a method comprising the steps of
a) communicating forwards with a first communication scheme (e.g. a differential scheme on a pair of differential lines),
b) communicating backwards with a second communication scheme (e.g. a common-mode level on the pair of differential lines),
said first and second communication schemes occurring over the same physical lines and being selected such that they are not disturbing each other.

For example, but not limited thereto, the forwards communication can be a burst signal, the backwards communication can be a reset signal, the first communication scheme can be a differential scheme on a pair of differential lines and the second communication scheme can be a common-mode level on the same pair of differential lines.

In an embodiment, the forwards communication comprises burst signals and the backwards communication comprises information on the end of said bursts.

According to the first aspect, the invention further relates to a system comprising
- a first signal processing system, provided for inputting a signal, processing said signal according to processing settings and outputting a first signal processed input signal in accordance with a first communication scheme,
- a second signal processing system, provided for receiving via one or more physical lines said first signal processed input signal in accordance with a first communication scheme, determining information needed for said first signal processing system for adapting its processing settings and outputting said information backwards via said one or more physical lines towards said first signal processing signal,
said first and second communication schemes being selected such that they are not disturbing each other.

For example, but not limited thereto, the forwards communication can be a burst signal, the backwards communication can be a reset signal, the first communication scheme can be a differential scheme on a pair of differential lines, the second communication scheme can be a common-mode level on the same pair of differential lines, the first signal processing system can comprise a first amplifier and a single-ended to differential convertor, the second signal processing system can comprise a second amplifier and common-mode level modification means, and the processing settings can be one or more of a gain of the first amplifier, a DC offset correction or another processing setting.

In an embodiment, the forwards communication comprises burst signals and the backwards communication comprises information on the end of said bursts, which may be used for triggering processing setting determination circuitry in said first signal processing system, for example for determining the gain or DC offset settings for an incoming burst.

### Brief description of the drawings

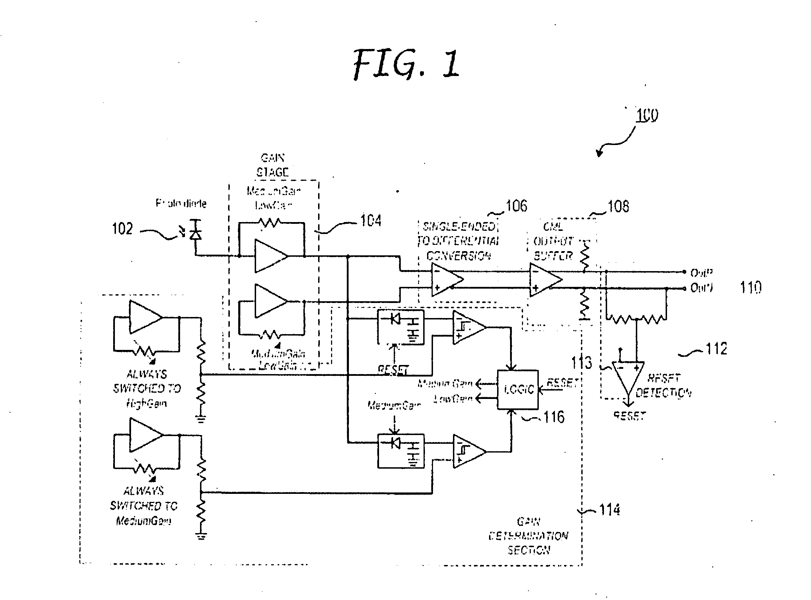

Figure 1 shows an example of a front-end (receiver) in accordance with the invention, in particular a photodiode is shown, a gain stage, a single-to-differential converter, a common-mode driving circuit and a common-mode level measurement means, connected to the differential outputs of said system, said means incorporating a differential amplifier, said means providing a reset signal towards a gain determination block.

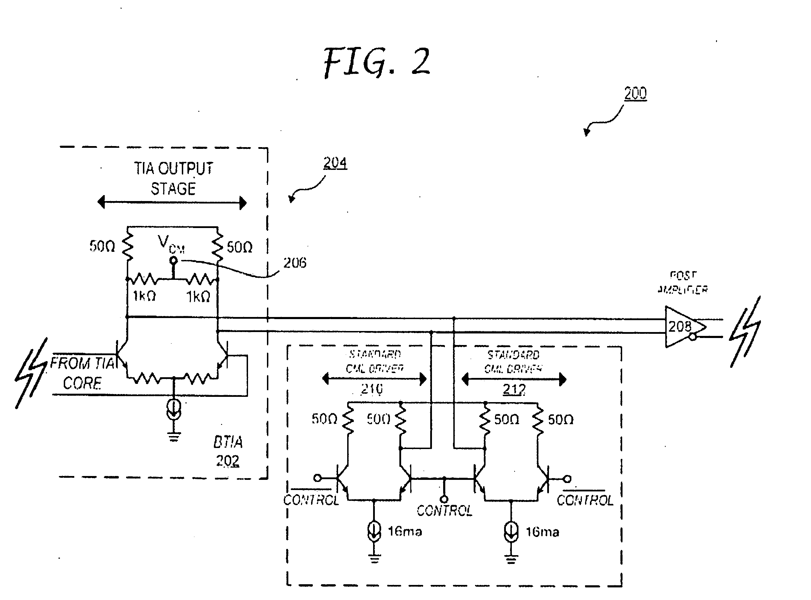

Figure 2 provides a circuit implementation of said common-mode level measurement means, in combination of the amplifier output stage circuit implementation, in particular a circuit implementation being an adaptation of standard common-mode logic drivers. The interconnection of the B-TIA output stage (left) with a pair of CML drive stages located in the post-amplifier chip, and connected to its differential inputs. The logic inputs marked "control" provide the post-amplifier with a means to modify the common mode level of this CML interconnection. This circuit implementation is an adaptation of standard common-mode logic circuitry, and allows for the transmission of information in the backwards direction, from post-amplifier to B-TIA.

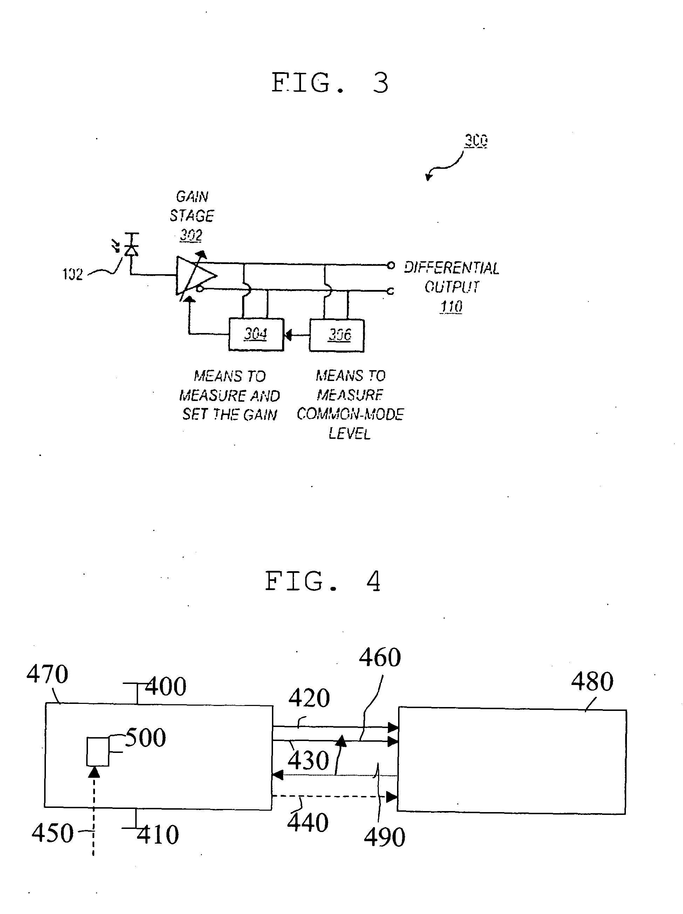

Figure 3 shows the concept of the invention, in particular a photo diode, a gain stage, providing a differential output, a means to modify the common-mode level, a means to determine from said common-model level the gain for said gain stage.
Figure 4 schematically shows a first preferred embodiment of the system of the invention, in particular the integration into a standard package with 4 or 5 pins.

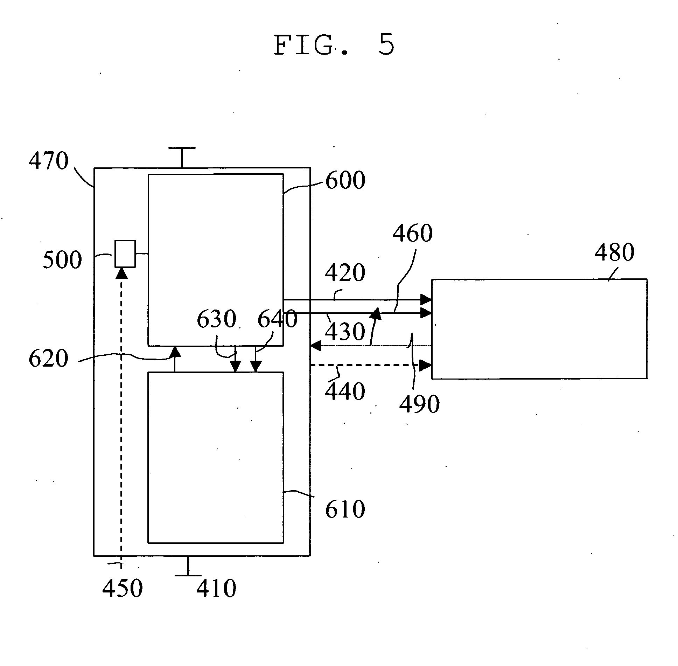

Figure 5 schematically shows a second preferred embodiment of the system of the invention, which is a specific embodiment of that of figure 4, in particular with a first part for first signal processing and a second part for determining processing settings for the first part on the basis of inputted signals/information.

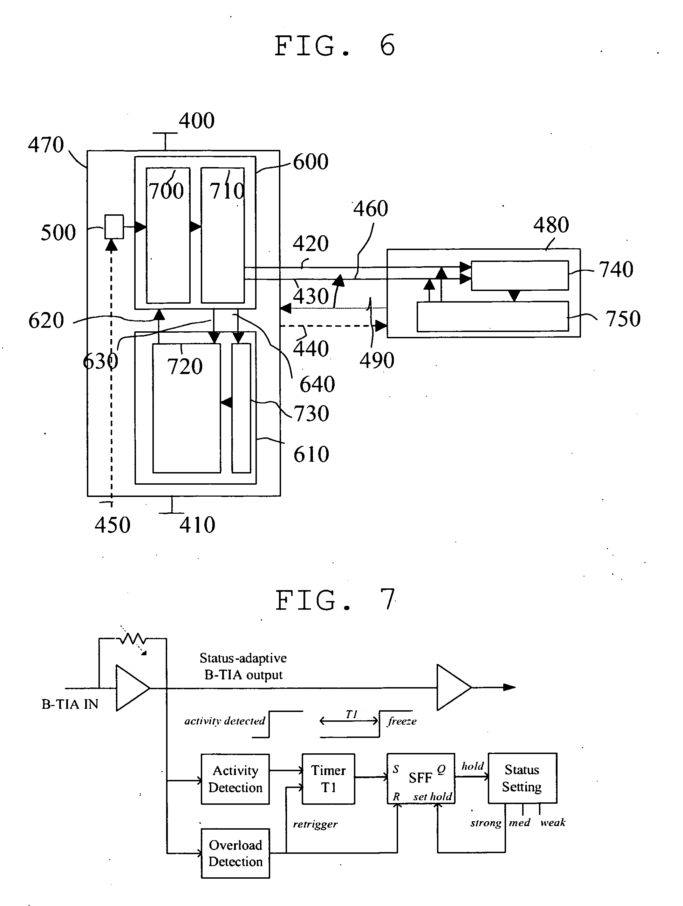

Figure 6 schematically shows a third preferred embodiment of the system of the invention, which is a specific embodiment of that of figure 4, in particular with an amplifier and a single-ended to differential converter in the first part and a reset signal receptor and a settings determination block in the second part.
Figure 7 shows the building blocks of a status freezing mechanism which can for example be incorporated in the front-end of figure 1 or in any other embodiment shown in figures 2-6.

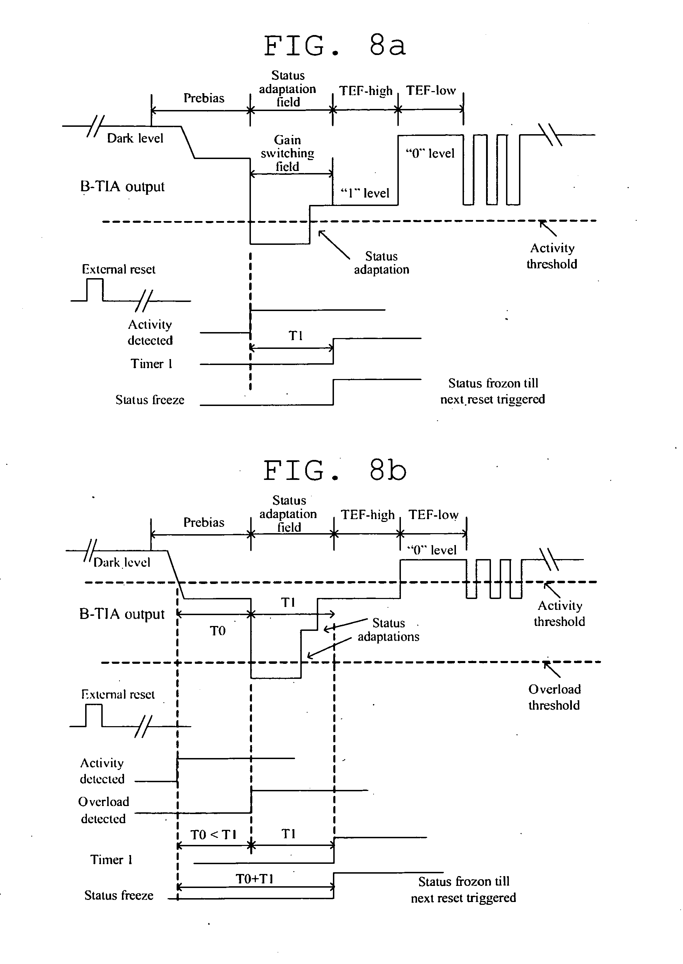

Figures 8a and b show examples of timing diagrams of the status freezing mechanism of figure 7. Figure 8a shows the situation in which the activity threshold is crossed by the onset of the Status Adaptation Field (situation b below). Figure 8b shows the situation in which the activity threshold is crossed prematurely by the laser prebias field of a strong burst (situation c below).

### Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

In the exemplary embodiment of figure 1, the invention provides a front-end (optical receiver) 100, for optical to electrical signal conversion, suited for use in optical access networks, in particular in gigabit passive optical network, said front-end being adapted for burst-mode reception with wide dynamic range. The front-end is so arranged that the gain is set within a few nanoseconds at the beginning of each incoming burst. The gain stage is provided by a transimpedance amplifier (TIA) 104 and the gain determination block 114 is an automatic gain control unit, preferably located at the very input of the front-end, is DC-coupled.

In an embodiment the developed burst-mode transimpedance amplifier (B-TIA) is intended for use in the optical line termination (OLT) of gigabit passive optical networks (GPON), wherein burst-mode operation is required, in order to be compliant to the ITU-T G.984.2 standard. The burst-mode TIA must handle the upstream burst-mode transmission. A special TIA is required, as the signal arriving at the OLT consists of a rapid sequence of bursts with widely varying amplitudes from burst to burst. In an embodiment of the invention the properties of this signal are such that the burst-mode TIA should be fully dc-coupled. Furthermore, to support the ITU-T G.984.2 class B, class B+ and class C operation, the TIA must have a large dynamic range, requiring an automatic gain control (AGC) scheme. Setting this burst-mode TIA apart from more conventional TIAs is the fact that the gain is set within a few nanoseconds at the beginning of each incoming burst, so that no valuable data are lost.

A major problem in the development of a TIA front-end for a GPON system is the fact that after each burst, a reset signal is needed to prepare the receiver circuitry for a next burst. Indeed, for example in a conventional burst-mode receiver the automatic gain control circuitry needs to be reset after each burst. As it is not possible to make a distinction between the guard time between bursts (which can be shorter than the maximum number of consecutive identical digits in a burst), in classical TIA's a reset signal needs to be provided externally to the TIA.

Usually, such a reset signal needs at least one additional I/O pad on the TIA chip and one additional I/O pin on the TIA package, the presence and cost which is to be avoided. This makes it difficult to integrate a TIA for GPON applications into the industry standard 5-pins TO-can package. Indeed, to ensure sufficient high sensitivity for class B, class B+ or class C operation an avalanche photodiode is required. Then, the following pins are needed:
- Positive supply voltage for the TIA
- Bias voltage for the avalanche photodiode
- Negative supply voltage for the TIA (gnd)
- Positive phase of the differential output
- Negative phase of the differential output

Hence, all 5 pins have been used, and no pins are left to provide a reset signal. In case only a PIN photodiode is used, one pin less can be used for monitoring. However, if one wants an additional RSSI (Received Signal Strength Indication) pin, the same problem remains, i.e. additional pins are needed on the TO-can package.

The system 100 of figure 1 is a front-end (receiver), for optical to electrical signal conversion, suited for use in gigabit passive optical networks, which can be operated in a first case 4 I/O pins or in a second case 5 I/O pins, in particular a positive and negative supply voltage, a positive and negative phase for use as differential output in the first case and a fifth I/O pin for providing a bias photodiode voltage in the second case.

The system 100 does hence not require the extra pad and pin and provides for integration of the photodiode and the B-TIA into a single, low cost, industry standard 5-pins TO-can package.

To avoid using an additional pin and still provide a reset signal, the common-mode level of the differential output is used as a means to signal a reset to the TIA. In an embodiment this is done in such a way, that standard CML (Current-Mode Logic) drivers can be used to create this reset signal. The circuit principle is shown in Fig. 2. Using two standard CML drivers, the common-mode level of the output stage of the TIA can be adjusted by the succeeding post-amplifier. It is straightforward for the B-TIA chip to detect a pulse on V_{CM}, hence a control signal can be sent by the post-amplifier and (re)generated inside the B-TIA chip without an additional pin. Such a control signal can be used to transmit information in backward direction, towards the B-TIA chip, e.g. to control an automatic gain control circuit on the B-TIA chip, as shown on Fig. 1.

Figure 1 is a diagram depicting a front-end (receiver) in accordance with an exemplary embodiment of the present invention. Front-end 100 is used in the optical line termination (OLT) of gigabit passive optical networks (GPON) and generally comprises optical-electrical conversion and amplification components for converting optical signals to electrical signals and varying the amplification to compensate for weak or intense light signals, as a result of these signals originating from different users. More particularly, conversion photodiode 102 receives a light signal from, for example, an optical fiber, and converting the optical light signals to electrical signals for use in B-TIA front-end 100. The output of photodiode 102 is electrically coupled to the input side of gain stage 104, which also receives variable gain setting information from gain determination section 114. Gain determination section 114 takes measurements from signals on the output gain stage 104 for determining information, such as a suitable B-TIA gain, in order to prepare the B-TIA for the next burst to be received. However, output gain stage 104 must be reset between bursts.

The output of gain stage 104 is also electrically coupled to the input side of single-ended to differential converter 106. Front-end 100 further comprises common-mode driving circuits 108 and common-mode level measurement section 112 for measuring the common-mode level of the differential outputs of the B-TIA. Common-mode level measurement section 112 incorporates differential amplifier 113, whereby common-mode level measurement section 112 can regenerate a reset signal for use by gain determination section 114.

The components shown in figure 1 may all be integrated into a single chip, a standard 4- or 5-pin package. The reset signal is generated outside this chip and sent backwards via a modification of the common-mode level of the differential lines 110. The common-mode level measurement section 112 detects this modification and thereupon warns the gain determination section 114. In other words, the common-mode level measurement section 112 acts as reset signal receptor.

Figure 2 is a diagram depicting a circuit implementation of the common-mode level modification section 200, by which the reset signal is generated, in combination of the B-TIA output stage circuit implementation 204 and a post amplifier 208, in accordance with an exemplary embodiment of the present invention. Common-mode level modification section 200, as depicted, shows an exemplary circuit implementation as being an adaptation of standard CML (Current-Mode Logic) drivers 210 and 212. As such, the standard CML drivers can be used to modify the common-mode of the differential line and so create the reset signal for the gain determination of the B-TIA 202.

B-TIA output stage 204 (left) is coupled with the differential inputs of post-amplifier 208 (i.e. with post-amplifier 208 residing on the post-amplifier chip, B-TIA output stage 204 is also connected to the differential inputs of the post-amplifier chip). The logic inputs labeled as "control" in CML drive stages 210 and 212 of the figure provide post-amplifier 208 with a means to modify the common-mode level of this CML interconnection. The post-amplifier 208 is provided for detecting the end of each burst in the incoming signal and thereupon controls the CML drivers 210 and 212 to modify the common-mode level. Hence a reset signal is created, which can be detected (or regenerated) inside the B-TIA chip 202 without an additional pin. In the B-TIA 202 the reset pulse is detected on V_{CM} 206 of the common-mode measurement section. The reset pulse used to trigger components in the chip which need to be reset after each burst, for example the automatic gain control circuit shown as gain determination section 114 in figure 1, or for example an automatic DC offset control circuit (not shown) or any other component which needs to be reset after each burst.

Figure 3 shows the concept of the invention more in general, in particular photodiode 102, amplifier with controllable gain stage 302 and converter for providing a differential output 110, gain determination section 304 which is connected to the differential lines for measurement purposes, e.g. for measuring the amplitude of the burst signal and determine a suitable gain setting for the gain stage 302 therefrom, and reset signal receptor 306 implement as means to measure the common-mode level. The measurement of amplitude or other characteristics of the incoming signal by gain (or other settings) determination section 304 may also be taken directly after the controllable gain stage 302, i.e. before the signal is converted to differential.

Figure 4 shows an embodiment of the system of the invention, integrated into chips with standard packages. A first chip 470 communicates with a second chip 480, via communication means, namely differential line 420 and 430, in a first forwards direction 460 (from first to second chip) and in a second backwards direction 490 on said same communication means 460.

The first forwards direction 460 of communication is implemented as a differential communication and the backwards direction 490 is implemented as common-mode signal over the same differential lines 420, 430. This arrangement enables the use of a minimum set of pins on said first chip 470, in particular a power supply 400, a ground 410 and two differential outputs 420 and 430 (also acting together as common-mode input). Optionally a fifth pin may be used, still within the specifications of standard packages, for either backbiasing 450 the photodiode 500, which forms the input for the signal to be transferred on the system, or for RSSI (Received Signal Strength Indication) monitoring 440, which may be foreseen.

The embodiment of figure 5 elaborates on the embodiment of figure 4. Here, the first chip 470 comprises a first part 600 and a second part 610. The first part performs signal processing and the second part determines processing settings for the first part. The first part 600 receives an input signal from the photodiode 500 and control 620 from the second part 610. The second part 610 receives as input measurement data 630 and a reset signal 640, which are here supplied via the first part 600. The measurement data 630 is obtained by measuring conditions of the signal under processing. The reset signal 640 indicates that said determining of new settings must be performed and is derived from the common-mode signal 490 sent back by the second chip 480.

The embodiment of figure 6 elaborates on the embodiment of figure 5. As shown, the second chip 480 comprises a part 740 function for detecting the need to adapt the signal processing settings of first part 600; for example part 740 can be an end-of-burst detector. This need to adapt settings is indicated to another part 750 for generating the backward signal by adapting the common mode signal level, so part 750 can be designated as reset signal generator. Said part 750 may be the common-mode buffer within chip 480.

In the first part 600 of the first chip 470, performing the signal processing, a signal adaptation block 700, e.g. an amplifier with controllable gain or a DC-offset correction or other, and a single-ended to differential converter 710 are provided. In the second part 610, determining the processing settings, a reset signal receptor 730 and a settings determination section 720 are provided. The reset signal receptor 730 detects the common-mode signal 640 and indicates the start of the procedure for determining processing settings to the settings determination section 720. The reset signal receptor may for example comprise a differential amplifier connected to both lines 420, 430 on one input and a reference on the other input. Alternatively the reset signal receptor 730 may be the common-mode buffer within block 710.

Upon being triggered by the reset signal receptor 730, the settings determination block 720 takes measurement data 630, which may for example comprise an amplitude and/or a DC-offset and/or another characteristic of the incoming signal coming from the photodiode 500, processes this data e.g. by comparison to one or more preset levels and returns a control signal 620 comprising the determined settings to the signal adaptation block 700. This control signal 620 may for example comprise a gain setting, a DC-offset setting or any other setting for adapting any other characteristic of the incoming signal.

In the following, the settings freezing mechanism of the invention will be described. The following abbreviations and definitions are used:
B-TIA: Burst-mode Translmpedance Amplifier
GPON: Gigabit Passive Optical Network
TEF: Threshold Extraction Field
SAF: Status Adaptation Field
SFF: Status Freeze Flipflop
SFM: Status-Freeze Mechanism

The GPON B-TIA of the exemplary embodiment of figure 1 includes circuitry to:
1. quickly change the gain of the B-TIA at the beginning of an incoming burst, by switching gain setting elements 104. The decision to perform this gain switching is based upon-the amplitude of the incoming burst.
2. reset the gain back into its initial status, and hence prepare the B-TIA for a new burst. For this purpose, an external reset signal is provided via a common-mode signaling mechanism 112 implemented on the B-TIA output.

Other designs may contain a different form of adaptation, changing the status of elements performing gain control, offset control or measurements, during the start of the incoming burst.

To cover the entire input signal dynamic range, status changes are needed within the B-TIA, or in the chip following the B-TIA, to be able to handle both weak signals (which require high gain and sensitivity) and strong signals (which require low gain and/or extra offset compensation).

The gain-adaptive B-TIA of figure 1 compares the input signal level against a number of predefined signal levels. Each time the input level exceeds such a predefined signal level, the gain is reduced by setting appropriate switches in the B-TIA front-end 100.

It is desired that the gain of the B-TIA is set quickly at the beginning of a burst (hereafter called the preamble), and that the gain status remains constant during the remaining portion of this burst. As will be described below, there are at least two situations which could result in sudden status switching during the remaining portion of the burst:
1. If the input signal level is very close to the point where the gain switching should occur, then a small increase in this input signal level, or any noise on this input signal level can trigger the gain switching mechanism. A small increase in this signal level or a noise peak may happen long after the end of the preamble, and hence the gain can switch suddenly alongside a packet.
2. If the input signal level is very close to the point where the gain switching should occur, then it is possible that the delay of the comparator used to compare the input signal level against a reference signal level where the switching should occur is much longer than expected. The gain switching can then occur much later after the beginning of the burst.

Similar problems may occur when other TIA settings are adapted, or when, the gain setting is performed differently. From these observations, it is clear that there is a need for a mechanism to freeze the TIA and/or limiting amplifier adaptation status once the first part of the preamble, during which adaptation is allowed, has passed.

A Status-Freeze Mechanism (SFM) that covers the peculiarities of the ITU-T G.984.x GPON signal is described hereafter. It is clear that the same or a similar SFM can be applied for any other type of GPON signals.

Let us consider a typical design of the first part of the preamble to be used in a GPON 1.25-Gb/s upstream channel. This is only a typical design, as the actual preamble fields and their time span may differ from one implementation to another.
- Minimum guard time after the end of the preceding burst = 25.6 ns
- Maximum length of the prebias field = 12.8 ns
- Status Adaptation Field (SAF): A number of bits needed for signal level measurement and status adaptation, e.g. 10 successive '1' bits, corresponding to 8 ns at 1.25Gbps.
- Threshold Extraction Field (TEF): Additional 1's needed for subsequent "high" level extraction, needed for the threshold extraction, e.g. 6 successive '1' bits, corresponding to 4.8 ns at 1.25 Gbps.
- Threshold Extraction Field: Additional 0's needed for subsequent "low" level extraction, needed for the threshold extraction, e.g. 6 successive '0' bits, corresponding to 4.8 ns at 1.25 Gbps.

The above preamble contents are programmable and controlled by the optical line termination (ITU-T G.984.x). The exact preamble composition may depend on the adaptation principles used, and on implementation details of the B-TIA and the following burst-mode limiting amplifier.

In order to allow for a correct threshold extraction, the SFM must freeze the front-end status prior to the start of the first TEF. In principle, two mechanisms are possible to define the exact moment in time when the gain must be frozen.

### 1. Status freezing after a synchronous reset.

This requires that the time interval between the external B-TIA reset signal and the start of each incoming burst is constant and known by the B-TIA. A fixed on-chip timer, triggered by this reset signal, could then generate a delayed status-freezing signal. As the synchronism must be accurate on a bit scale, this imposes a severe requirement on the generation and transport of the external reset signal. Another disadvantage is that this synchronous approach cannot be used during ranging, where the time gap between reset and start of burst is unknown, and no synchronous reset can be provided.

### 2. Status freezing after an asynchronous reset.

An asynchronous reset places the B-TIA in a high-sensitivity status, which can last for an undefined time span until a burst arrives. A simple implementation requires that the B-TIA can detect the start of a new burst accurately and unambiguously, e.g. by detecting the crossing of a preset activity threshold level. The high dynamic range of the GPON signals however makes that several situations can happen:
a) The incoming signal is weaker than the activity threshold.
b) The activity threshold is crossed by the start of the SAF. This is the preferred situation.
c) The activity threshold is crossed prematurely by the laser prebias field of a strong burst.

What follows is a method and circuit that deals with these issues, and provides accurate status freezing in all circumstances including ranging, as it does not rely on synchronism between the external reset signal and the instant of arrival of the new burst. So, as long as the burst signal does not show excessive level increases (which would result in bit errors in the subsequent receiver chain anyhow), no status changes will occur after the SAF, and the timing requirements on the external reset signal are much relaxed.

Although the circuit is designed for a gain-switching 1.25Gbps GPON B-TIA, that can switch between three different states ('weak burst' after external reset, 'medium burst' and 'strong burst'), the method can easily deal with any adaptation mechanism in a TIA or optical front-end that is related to the properties of the incoming burst, and is only allowed to occur during a limited time window, such as, but not limited to:
- discrete gain setting (gain switching) with more or less gain states.
- continuous gain setting
- an adaptive offset compensation during the first part of the preamble
- a measurement of the burst properties during the start of the preamble, such as signal level(s), offset, duty cycle etc.

This method is generic, and can also operate at very different data rates, and in other burst-mode front ends used in electronic communication, radar, sonar or in instrumentation.

The method relies on the definition of two signal level thresholds, an activity threshold and an overload threshold. It assumes that an external reset has occurred, placing the B-TIA and its associated logic in a 'weak burst' state for an indefinite time. Figure 7 gives a circuit block diagram, and the associated timing waveforms for GPON are shown in figure 8. Following actions are taken depending on the three situations mentioned above:

### a) The incoming signal is weaker than the activity threshold.

An activity threshold is defined that is sufficiently below the decision level for a first adaptation, e.g. the switching from 'weak burst' to 'medium burst' setting. Weak bursts that pass under this activity threshold will not activate the adaptation mechanism. As the activity threshold is well below the first adaptation threshold, only strong increases of the burst level could cause the onset of an adaptation later during this burst.

For weak bursts, no status-freezing is performed, and the B-TIA acts as a highly-sensitive, time-invariant front-end amplifying weak signals.

### b) The activity threshold is crossed by the onset of the Status Adaptation Field..

When the incoming burst crosses the activity threshold, the activity detect circuit triggers Timer1. Upon completion of this time delay, the gain settings, or all adaptations made till this moment, are frozen in the actual status by setting the Status Freeze Flipflof (SFF), which holds the logic circuitry marked as "Status Setting" in a fixed status.

### c) The activity threshold is crossed prematurely by the laser prebias field of a strong burst.

Again, the activity detect circuit triggers timer T1, and upon completion of this time delay, all status settings are frozen in the actual status. As the activity detection is premature, there is a possibility that the status setting is not completed when timer T1 runs out, and that the onset of the SAF following the prebias causes an overload. This is detected by overload detection, comparing the signal level with an overload threshold that is sufficiently above the allowed 1 output level. Overload detection extends the status-adaptation time window by retriggering timer T1. In most cases, T1 will not have completed its preset time delay, and the retriggering acting makes T1 add a full time delay. In case of a long prebias however, when T1 had completed its time delay, this retriggering will reset the status freeze flipflop SFF again and start a second status-adaptation window.

A feedback link from the Status Setting logic to the Status Freeze Flipflop SFF assures that, whenever the 'strong burst' status is reached, this status is frozen until the arrival of an external B-TIA reset.

The timing diagrams (Fig 8a and b) illustrate the successive events in each of the situations b and c.

## Claims

1. A system for transferring incoming single-ended burst signals of which at least one characteristic varies widely from burst to burst onto a pair of differential lines, said system comprising:
- an input for receiving an incoming burst signal,
- a signal adaptation block (700) with at least one controllable adaptation element connected to said input and provided for adapting said at least one widely varying characteristic of the incoming burst signal,
- a single-ended-to-differential converter (106,710) connected to said signal adaptation block for converting the burst signal to a differential signal to be placed on said pair of differential lines in forwards direction,
- an end-of-burst detector (740) connected to said pair of differential lines and provided for detecting burst ends in said differential signal,
- a reset signal generator (750) connected to said end-of-burst detector for generating a reset signal to be placed on said differential lines in backwards direction upon detection of one of said burst ends,
- a reset signal receptor (112, 306, 730) connected to said pair of differential lines backwards from said reset signal generator, for receiving said reset signal,
- a settings determination block (720) connected to said reset signal receptor and said signal adaptation block, for controlling each adaptation element of said signal adaptation block upon receipt of said reset signal on the basis of a measurement of the incoming burst signal.

2. A system according to claim 1, **characterized in that** the reset signal generator is provided for modifying the common-mode level on the differential lines and that the reset signal receptor is a common-mode level measurement block.

3. A system according to claim 1 or 2, **characterized in that** said input, said signal adaptation block, said single-ended-to-differential converter, said reset signal receptor and said settings determination block are integrated in a first chip and that said end-of-burst detector and said reset signal generator are integrated in a second chip, said first and second chips being connected by means of said pair of differential lines.

4. A system according to any one of the previous claims, **characterized in that** said input is formed by a photodiode for placement at a termination of an optical line.

5. A system according to any one of the claims 1-4, **characterized in that** said first chip is a four I/O pins package with two pins for a positive and a negative supply voltage and two pins forming a differential output for connection to said pair of differential lines.

6. A system according to any one of the claims 1-4, **characterized in that** said first chip is a five I/O pins package with two pins for a positive and a negative supply voltage, two pins forming a differential output for connection to said pair of differential lines and one pin for providing a received signal strength indication.

7. A system according to claim 4, **characterized in that** said first chip is a five I/O pins package with two pins for a positive and a negative supply voltage, two pins forming a differential output for connection to said pair of differential lines and one pin for supplying a bias voltage to said photodiode.

8. A system according to any one of the previous claims, **characterized in that** said end-of-burst detector is comprised in a post amplifier on said differential lines.

9. A system according to any one of the claims 1-8, **characterized in that** said at least one widely varying characteristic comprises an amplitude of the signal, that said signal adaptation block comprises an amplifier with controllable gain and that said settings determination block is provided for controlling said amplifier on the basis of an amplitude measurement of said incoming burst signal.

10. A system according to any one of the claims 1-9, **characterized in that** said at least one widely varying characteristic comprises a DC-offset of the signal, that said signal adaptation block comprises a DC-offset correction element and that said settings determination block is provided for controlling said DC-offset correction element on the basis of a DC-offset measurement of said incoming burst signal.

11. A method for transferring incoming single-ended burst signals with at least one characteristic which varies widely from burst to burst onto a pair of differential lines, said method comprising the steps of:
a) receiving an incoming burst signal on an input,
b) adapting said at least one characteristic of the incoming burst signal by means of a signal adaptation block (700) with at least one controllable adaptation element connected to said input,
c) converting the burst signal to a differential signal to be placed on said pair of differential lines in forwards direction by means of a single-ended-to-differential converter (106; 710) connected to said signal adaptation block,
d) detecting burst ends in said differential signal by means of an end-of-burst detector (740) connected to said pair of differential lines,
e) upon detection of one of said burst ends, generating a reset signal to be placed on said differential lines in backwards direction by means of a reset signal generator (750) connected to said end-of-burst detector,
f) receiving said reset signal by means of a reset signal receptor (112, 306, 730) connected to said pair of differential lines backwards from said reset signal generator,
g) upon receipt of said reset signal, controlling each adaptation element of said signal adaptation block on the basis of a measurement of an incoming burst by means of a settings determination block (720) connected to said reset signal receptor and said signal adaptation block.

12. A method according to claim 11, **characterized in that** the reset signal is generated by modifying the common-mode level on the differential lines, the reset signal receptor being a common-mode level measurement block.

13. A system according to any one of the claims 1-9, **characterized in that** each incoming burst comprises a preamble and a subsequent data section and **in that** said system further comprises a status freezing mechanism connected to said input and said settings determination block, for freezing each adaptation element of said signal adaptation block during treatment of said data section of each incoming burst.

14. A system according to claim 13, **characterized in that** the status freezing mechanism comprises:
- an activity detection block connected to said input for detecting the start of said preamble, said activity detection block being provided for comparing the incoming burst with an activity threshold,
- a timer connected to said activity detection block, said timer having a predetermined time delay in function of the duration of said preamble, the activity detection block being adapted for triggering the timer upon crossing of the activity threshold,
- a freezing signal generator connected to said timer and said settings determination block, for generating a freezing signal upon completion of said time delay.

15. A system according to claim 14, **characterized in that** the status freezing mechanism further comprises:
- an overload detection block connected to said input and adapted for retriggering said timer and said freezing signal generator, said overload detection block being provided for comparing the incoming burst with an overload threshold and retriggering said timer and said freezing signal generator upon crossing of the overload threshold.

## Patentansprüche

1. System zum Übertragen eingehender Eintakt-Burst-Signale, bei welchen mindestens eine Eigenschaft von Burst zu Burst breit variiert, auf einem Paar differenzieller Leitungen, das System Folgendes umfassend:
- einen Eingang zum Empfangen eines eingehenden Burst-Signals,
- einen Signalanpassungsblock (700) mit mindestens einem steuerbaren Anpassungselement, welches mit dem Eingang verbunden ist und zum Anpassen der mindestens einen breit variierenden Eigenschaft des eingehenden Burst-Signals bereitgestellt ist,
- einen Eintakt-nach-Differenz-Wandler (106, 710), welcher mit dem Signalanpassungsblock verbunden ist, zum Umwandeln des Burst-Signals in ein Differenzsignal, welches in Vorwärtsrichtung auf dem Paar differenzieller Leitungen platziert werden soll,
- einen Burst-Ende-Detektor (740), welcher mit dem Paar differenzieller Leitungen verbunden ist und zum Detektieren von Burst-Enden in dem Differenzsignal bereitgestellt ist,
- einen Rücksetzsignalerzeuger (750), welcher mit dem Burst-Ende-Detektor verbunden ist, zum Erzeugen eines Rücksetzsignals, welches bei Detektion eines der Burst-Enden in Rückwärtsrichtung auf den differenziellen Leitungen platziert werden soll,
- einen Rücksetzsignalrezeptor (112, 306, 730), welcher mit dem Paar differenzieller Leitungen hinter dem Rücksetzsignalerzeuger verbunden ist, zum Empfangen des Rücksetzsignals,
- einen Einstellungsbestimmungsblock (720), welcher mit dem Rücksetzsignalrezeptor und dem Signalanpassungsblock verbunden ist, zum Steuern jedes Anpassungselements des Signalanpassungsblocks bei Empfang des Rücksetzsignals auf der Grundlage einer Messung des eingehenden Burst-Signals.

2. System nach Anspruch 1, **dadurch gekennzeichnet, dass** der Rücksetzsignalerzeuger zum Modifizieren des Gleichtaktpegels auf den differenziellen Leitungen bereitgestellt ist und dass der Rücksetzsignalrezeptor ein Gleichtaktpegel-Messblock ist.

3. System nach Anspruch 1 oder 2, **dadurch gekennzeichnet, dass** der Eingang, der Signalanpassungsblock, der Eintakt-nach-Differenz-Wandler, der Rücksetzsignalrezeptor und der Einstellungsbestimmungsblock in einem ersten Chip integriert sind und dass der Burst-Ende-Detektor und der Rücksetzsignalerzeuger in einem zweiten Chip integriert sind, wobei der erste und der zweite Chip mittels des Paares differenzieller Leitungen verbunden sind.

4. System nach einem der vorhergehenden Ansprüche, **dadurch gekennzeichnet, dass** der Eingang durch eine Fotodiode zur Platzierung an einer Terminierung einer optischen Leitung ausgebildet ist.

5. System nach einem der Ansprüche 1 bis 4, **dadurch gekennzeichnet, dass** der erste Chip ein Paket mit vier E/A-Kontaktstiften ist, wobei zwei Kontaktstifte für eine positive und eine negative Versorgungsspannung sind und zwei Kontaktstifte einen differenziellen Ausgang zum Anschluss an das Paar differenzieller Leitungen ausbilden.

6. System nach einem der Ansprüche 1 bis 4, **dadurch gekennzeichnet, dass** der erste Chip ein Paket mit fünf E/A-Kontaktstiften ist, wobei zwei Kontaktstifte für eine positive und eine negative Versorgungsspannung sind, zwei Kontaktstifte einen differenziellen Ausgang zum Anschluss an das Paar differenzieller Leitungen ausbilden und ein Kontaktstift zum Bereitstellen einer Stärkeangabe des empfangenen Signals ist.

7. System nach Anspruch 4, **dadurch gekennzeichnet, dass** der erste Chip ein Paket mit fünf E/A-Kontaktstiften ist, wobei zwei Kontaktstifte für eine positive und eine negative Versorgungsspannung sind, zwei Kontaktstifte einen differenziellen Ausgang zum Anschluss an das Paar differenzieller Leitungen ausbilden und ein Kontaktstift zum Liefern einer Vorspannung an die Fotodiode ist.

8. System nach einem der vorhergehenden Ansprüche, **dadurch gekennzeichnet, dass** der Burst-Ende-Detektor in einen Nachverstärker auf den differenziellen Leitungen einbezogen ist.

9. System nach einem der Ansprüche 1 bis 8, **dadurch gekennzeichnet, dass** die mindestens eine breit variierende Eigenschaft eine Amplitude des Signals umfasst, dass der Signalanpassungsblock einen Verstärker mit einem steuerbaren Verstärkungswert umfasst und dass der Einstellungsbestimmungsblock zum Steuern des Verstärkers auf der Grundlage einer Amplitudenmessung des eingehenden Burst-Signals bereitgestellt ist.

10. System nach einem der Ansprüche 1 bis 9, **dadurch gekennzeichnet, dass** die mindestens eine breit variierende Eigenschaft einen Gleichspannungsversatz des Signals umfasst, dass der Signalanpassungsblock ein Korrekturelement für den Gleichspannungsversatz umfasst und dass der Einstellungsbestimmungsblock zum Steuern des Korrekturelements für den Gleichspannungsversatz auf der Grundlage einer Messung des Gleichspannungsversatzes des eingehenden Burst-Signals bereitgestellt ist.

11. Verfahren zum Übertragen eingehender Eintakt-Burst-Signale mit mindestens einer Eigenschaft, welche von Burst zu Burst breit variiert, auf einem Paar differenzieller Leitungen, das Verfahren die folgenden Schritte umfassend:
a) Empfangen eines eingehenden Burst-Signals auf einem Eingang,
b) Anpassen der mindestens einen Eigenschaft des eingehenden Burst-Signals mittels eines Signalanpassungsblocks (700) mit mindestens einem steuerbaren Anpassungselement, welches mit dem Eingang verbunden ist,
c) Umwandeln des Burst-Signals in ein Differenzsignal, welches in Vorwärtsrichtung auf dem Paar differenzieller Leitungen platziert werden soll, mittels eines Eintakt-nach-Differenz-Wandlers (106, 710), welcher mit dem Signalanpassungsblock verbunden ist,
d) Detektieren von Burst-Enden in dem Differenzsignal mittels eines Burst-Ende-Detektors (740), welcher mit dem Paar differenzieller Leitungen verbunden ist,
e) Erzeugen eines Rücksetzsignals bei Detektion eines der Burst-Enden, welches in Rückwärtsrichtung auf den differenziellen Leitungen platziert werden soll, mittels eines Rücksetzsignalerzeugers (750), welcher mit dem Burst-Ende-Detektor verbunden ist,
f) Empfangen des Rücksetzsignals mittels eines Rücksetzsignalrezeptors (112, 306, 730), welcher hinter dem Rücksetzsignalerzeuger mit dem Paar differenzieller Leitungen verbunden ist,
g) Steuern jedes Anpassungselements des Signalanpassungsblocks bei Empfang des Rücksetzsignals auf der Grundlage einer Messung eines eingehenden Bursts mittels eines Einstellungsbestimmungsblocks (720), welcher mit dem Rücksetzsignalrezeptor und dem Signalanpassungsblock verbunden ist.

12. Verfahren nach Anspruch 11, **dadurch gekennzeichnet, dass** das Rücksetzsignal durch Modifizieren des Gleichtaktpegels auf den differenziellen Leitungen erzeugt wird, wobei der Rücksetzsignalrezeptor ein Gleichtaktpegel-Messblock ist.

13. System nach einem der Ansprüche 1 bis 9, **dadurch gekennzeichnet, dass** jeder eingehender Burst einen Vorspann und einen nachfolgenden Datenabschnitt umfasst und dadurch, dass das System weiterhin einen Statuseinfriermechanismus, welcher mit dem Eingang und dem Einstellungsbestimmungsblock verbunden ist, zum Einfrieren jedes Anpassungselements des Signalanpassungsblocks während einer Behandlung eines Datenabschnitts jedes eingehenden Bursts umfasst.

14. System nach Anspruch 13, **dadurch gekennzeichnet, dass** der Statuseinfriermechanismus Folgendes umfasst:
- einen Aktivitätsdetektionsblock, welcher mit dem Eingang verbunden ist, zum Detektieren des Beginns des Vorspanns, wobei der Aktivitätsdetektionsblock zum Vergleichen des eingehenden Bursts mit einem Aktivitätsschwellenwert bereitgestellt ist,
- einen Zeitgeber, welcher mit dem Aktivitätsdetektionsblock verbunden ist, wobei der Zeitgeber eine vorbestimmte Zeitverzögerung als Funktion der Dauer des Vorspanns aufweist, wobei der Aktivitätsdetektionsblock zum Auslösen des Zeitgebers bei Überschreiten des Aktivitätsschwellenwerts eingerichtet ist,
- einen Einfriersignalerzeuger, welcher mit dem Zeitgeber und dem Einstellungsbestimmungsblock verbunden ist, zum Erzeugen eines Einfriersignals bei Ablauf der Zeitverzögerung.

15. System nach Anspruch 14, **dadurch gekennzeichnet, dass** der Statuseinfriermechanismus weiterhin Folgendes umfasst:
- einen Überlastdetektionsblock, welcher mit dem Eingang verbunden ist und zum erneuten Auslösen des Zeitgebers und des Einfriersignalerzeugers eingerichtet ist, wobei der Überlastdetektionsblock zum Vergleichen des eingehenden Bursts mit einem Überlastschwellenwert und zum erneuten Auslösen des Zeitgebers und des Einfriersignalerzeugers bei Überschreiten des Überlastschwellenwerts bereitgestellt ist.

## Revendications

1. Système pour transférer des signaux de salve monocordes entrants dont au moins une caractéristique varie largement d'une salve à l'autre sur une paire de lignes différentielles, ledit système comprenant :
- une entrée pour recevoir un signal de salve entrant,
- un bloc d'adaptation de signal (700) avec au moins un élément d'adaptation contrôlable connecté à ladite entrée et prévu pour adapter ladite au moins une caractéristique variant largement du signal de salve entrant,
- un convertisseur monocorde - différentiel (106, 710) connecté audit bloc d'adaptation de signal pour convertir le signal de salve en un signal différentiel à placer sur ladite paire de lignes différentielles dans la direction avant,
- un détecteur de fin de salve (740) connecté à ladite paire de lignes différentielles et prévu pour détecter des fins de salve dans ledit signal différentiel,
- un générateur de signal de réinitialisation (750) connecté audit détecteur de fin de salve pour générer un signal de réinitialisation à placer sur lesdites lignes différentielles dans la direction arrière lors de la détection d'une desdites fins de salve,
- un récepteur de signal de réinitialisation (112, 306, 730) connecté à ladite paire de lignes différentielles en arrière dudit générateur de signal de réinitialisation pour recevoir ledit signal de réinitialisation,
- un bloc de détermination de paramètres (720) connecté audit récepteur de signal de réinitialisation et audit bloc d'adaptation de signal pour contrôler chaque élément d'adaptation dudit bloc d'adaptation de signal lors de la réception dudit signal de réinitialisation sur la base d'une mesure du signal de salve entrant.

2. Système selon la revendication 1, **caractérisé en ce que** le générateur de signal de réinitialisation est prévu pour modifier le niveau de mode commun sur les lignes différentielles et **en ce que** le récepteur de signal de réinitialisation est un bloc de mesure de niveau de mode commun.

3. Système selon la revendication 1 ou 2, **caractérisé en ce que** ladite entrée, ledit bloc d'adaptation de signal, ledit convertisseur monocorde - différentiel, ledit récepteur de signal de réinitialisation et ledit bloc de détermination de paramètres sont intégrés dans une première puce et **en ce que** le détecteur de fins de salve et ledit générateur de signal de réinitialisation sont intégrés dans une deuxième puce, lesdites première et deuxième puces étant connectées au moyen de ladite paire de lignes différentielles.

4. Système selon l'une quelconque des revendications précédentes, **caractérisé en ce que** ladite entrée est formée par une photodiode pour placement à une terminaison d'une ligne optique.

5. Système selon l'une quelconque des revendications 1 - 4, **caractérisé en ce que** ladite première puce est un paquet de quatre broches E/S avec deux broches pour une tension d'alimentation positive et une tension d'alimentation négative et deux broches formant une sortie différentielle à connecter à ladite paire de lignes différentielles.

6. Système selon l'une quelconque des revendications 1 - 4, **caractérisé en ce que** ladite première puce est un paquet de cinq broches E/S avec deux broches pour une tension d'alimentation positive et une tension d'alimentation négative, deux broches formant une sortie différentielle à connecter à ladite paire de lignes différentielles et une broche pour fournir une indication d'intensité de signal reçu.

7. Système selon la revendication 4, **caractérisé en ce que** ladite première puce est un paquet de cinq broches E/S avec deux broches pour une tension d'alimentation positive et une tension d'alimentation négative, deux broches formant une sortie différentielle à connecter à ladite paire de lignes différentielles et une broche pour fournir une tension de polarisation à ladite photodiode.

8. Système selon l'une quelconque des revendications précédentes, **caractérisé en ce que** ledit détecteur de fin de salve est compris dans un post-amplificateur sur lesdites lignes différentielles.

9. Système selon l'une quelconque des revendications 1 - 8, **caractérisé en ce que** ladite au moins une caractéristique variant largement comprend une amplitude du signal, **en ce que** ledit bloc d'adaptation de signal comprend un amplificateur à gain contrôlable et **en ce que** ledit bloc de détermination de paramètres est prévu pour contrôler ledit amplificateur sur la base d'une mesure d'amplitude dudit signal de salve entrant.

10. Système selon l'une quelconque des revendications 1 - 9, **caractérisé en ce que** ladite au moins une caractéristique variant largement comprend un élément de correction de décalage CC et **en ce que** ledit bloc de détermination de paramètres est prévu pour contrôler ledit élément de correction de décalage CC sur la base d'une mesure de décalage CC dudit signal de salve entrant.

11. Procédé pour transférer des signaux de salve monocordes entrants ayant au moins une caractéristique qui varie largement d'une salve à l'autre sur une paire de lignes différentielles, ledit procédé comprenant les étapes consistant à :
a) recevoir un signal de salve entrant sur une entrée,
b) adapter ladite au moins une caractéristique du signal de salve entrant au moyen d'un bloc d'adaptation de signal (700) avec au moins un élément d'adaptation contrôlable connecté à ladite entrée,
c) convertir le signal de salve en un signal différentiel à placer sur ladite paire de lignes différentielles dans la direction avant au moyen d'un convertisseur monocorde - différentiel (106, 710) connecté audit bloc d'adaptation de signal,
d) détecter des fins de salve dans ledit signal différentiel au moyen d'un détecteur de fin de salve (740) connecté à ladite paire de lignes différentielles,
e) générer, lors de la détection d'une desdites fins de salve, un signal de réinitialisation à placer sur lesdites lignes différentielles dans la direction arrière au moyen d'un générateur de signal de réinitialisation (750) connecté audit détecteur de fin de salve,
f) recevoir ledit signal de réinitialisation au moyen d'un récepteur de signal de réinitialisation (112, 306, 730) connecté à ladite paire de lignes différentielles en arrière dudit générateur de signal de réinitialisation,
g) contrôler, lors de la réception dudit signal de réinitialisation, chaque élément d'adaptation dudit bloc d'adaptation de signal sur la base d'une mesure d'une salve entrante au moyen d'un bloc de détermination de paramètres (720) connecté audit récepteur de signal de réinitialisation et audit bloc d'adaptation de signal.

12. Procédé selon la revendication 11, **caractérisé en ce que** le signal de réinitialisation est généré en modifiant le niveau de mode commun sur les lignes différentielles, le récepteur de signal de réinitialisation étant un bloc de mesure de niveau de mode commun.

13. Système selon l'une quelconque des revendications 1 - 9, **caractérisé en ce que** chaque salve entrante comprend un préambule et une section de données subséquente et **en ce que** ledit système comprend en outre un mécanisme de gel d'état connecté à ladite entrée et audit bloc de détermination de paramètres pour geler chaque élément d'adaptation dudit bloc d'adaptation de signal pendant le traitement de ladite section de données de chaque salve entrante.

14. Système selon la revendication 13, **caractérisé en ce que** le mécanisme de gel d'état comprend :
- un bloc de détection d'activité connecté à ladite entrée pour détecter le début dudit préambule, ledit bloc de détection d'activité étant prévu pour comparer la salve entrante avec un seuil d'activité,
- une minuterie connectée audit bloc de détection d'activité, ladite minuterie ayant une temporisation prédéterminée en fonction de la durée dudit préambule, le bloc de détection d'activité étant adapté pour déclencher la minuterie lors du franchissement du seuil d'activité,
- un générateur de signal de gel connecté à ladite minuterie et audit bloc de détermination de paramètres pour générer un signal de gel lors de l'achèvement de ladite temporisation.

15. Système selon la revendication 14, **caractérisé en ce que** le mécanisme de gel d'état comprend en outre :
- un bloc de détection de surcharge connecté à ladite entrée et adapté pour redéclencher ladite minuterie et ledit générateur de signal de gel, ledit bloc de détection de surcharge étant prévu pour comparer la salve entrante avec un seuil de surcharge et pour redéclencher ladite minuterie et ledit générateur de signal de gel lors du franchissement du seuil de surcharge.
